(19) Europäisches Patentamt
European Patent Office
Office européen des brevets

(11) **EP 4 692 931 A1**

(12) **EUROPEAN PATENT APPLICATION**
published in accordance with Art. 153(4) EPC

(43) Date of publication:
**11.02.2026 Bulletin 2026/07**

(21) Application number: **24780222.6**

(22) Date of filing: **25.03.2024**

(51) International Patent Classification (IPC):
**G03F 1/62** (2012.01)

(52) Cooperative Patent Classification (CPC):
**G03F 1/62**

(86) International application number:
**PCT/JP2024/011772**

(87) International publication number:
**WO 2024/204106 (03.10.2024 Gazette 2024/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.03.2023 JP 2023051836**

(71) Applicant: **LINTEC CORPORATION**
**Itabashi-ku**
**Tokyo 173-0001 (JP)**

(72) Inventors:
• **KAWAHARA, Jun**
**Tokyo 173-0001 (JP)**
• **KUBO, Shuhei**
**Tokyo 173-0001 (JP)**
• **HAGIHARA, Yoshiaki**
**Tokyo 173-0001 (JP)**

(74) Representative: **Gille Hrabal**
**Partnerschaftsgesellschaft mbB**
**Patentanwälte**
**Brucknerstraße 20**
**40593 Düsseldorf (DE)**

(54) **PELLICLE FILM AND PELLICLE**

(57) A pellicle film (100) contains a first fibrous material (1) and a second fibrous material (2). A length $L_{FB1}$ of the first fibrous material (1) is 20 μm or less, and a length $L_{FB2}$ of the second fibrous material (2) is 100 μm or more and less than 250 μm. A pellicle (200) includes the pellicle film (100) and a support (30) that has a frame (31) and an opening (32) surrounded by the frame (31) and that supports the pellicle film (100).

FIG.4

EP 4 692 931 A1

**Description**

TECHNICAL FIELD

The present invention relates to a pellicle film and a pellicle.

BACKGROUND ART

In a process of manufacturing a semiconductor device or the like, for example, a photoresist is applied to a substrate such as a semiconductor wafer, the substrate having the photoresist thereon is irradiated with light using a photomask, and the photoresist is removed to thereby form a desired circuit pattern on the substrate.

If light is applied in a state where foreign matter adheres to the photomask, the adhering foreign matter may adversely affect the circuit pattern formed on the substrate. Therefore, in order to inhibit adhesion of foreign matter to the photomask, a pellicle including a pellicle film that captures foreign matter is used in some cases. The pellicle is disposed above the photomask at a distance such that the pellicle film is not in contact with the photomask.

In recent years, use of extreme ultra violet (EUV) has been studied in order to form a finer circuit pattern. EUV means light with a wavelength in a range from 1 nm to 100 nm. For example, specifically, a light beam with a wavelength of about 13.5 nm $\pm$ 0.3 nm is being used as EUV. When a pellicle film is irradiated with EUV, although the EUV is transmitted through the pellicle film, part of the radiated EUV is absorbed by the pellicle film. The light energy of absorbed EUV is converted into thermal energy, and the temperature of the pellicle film is thereby increased. Thus, the pellicle film is required to have, for example, EUV transmissivity, heat resistance, and durability.

For example, Patent Literature 1 describes a pellicle film including a carbon nanotube sheet. Patent Literature 1 discloses that the carbon nanotube sheet in the pellicle film is provided with bundles, each of which is formed of a plurality of carbon nanotubes and has a diameter of 100 nm or less, and the bundles are in-plane oriented in the carbon nanotube sheet. Patent Literature 1 discloses that the pellicle film has high EUV transmissivity and good heat resistance.

CITATION LIST

PATENT LITERATURE(S)

Patent Literature 1: International Publication No. 2018/008594

SUMMARY OF THE INVENTION

PROBLEM(S) TO BE SOLVED BY THE INVENTION

To obtain a pellicle film that has higher performance, it is desirable to provide a pellicle film whose void characteristics (for example, a void diameter and an aperture ratio) are easily controlled.

An object of the invention is to provide a pellicle film whose void characteristics are easily controlled and to provide a pellicle including the pellicle film.

MEANS FOR SOLVING THE PROBLEM(S)

[1]. A pellicle film containing a first fibrous material and a second fibrous material,

in which a length $L_{FB1}$ of the first fibrous material is 20 $\mu$m or less, and
a length $L_{FB2}$ of the second fibrous material is 100 $\mu$m or more and less than 250 $\mu$m.

[2]. The pellicle film according to [1],

in which the pellicle film is a single-layer film, and
the first fibrous material and the second fibrous material coexist in the single-layer film.

[3]. The pellicle film according to [2],
in which a mass ratio ($M_{FB1}$:$M_{FB2}$) of a mass $M_{FB1}$ of the first fibrous material to a mass $M_{FB2}$ of the second fibrous material in the single-layer film is 10:90 to 90:10.

[4]. The pellicle film according to [2] or [3],
in which a total of a mass percentage of the first fibrous material in the single-layer film and a mass percentage of the second fibrous material in the single-layer film is 90 mass% or more.

[5]. The pellicle film according to [1],

in which the pellicle film is a multilayer film including a first pellicle film and a second pellicle film,
the first pellicle film and the second pellicle film are stacked,
the first pellicle film contains the first fibrous material, and
the second pellicle film contains the second fibrous material.

[6]. The pellicle film according to [5],
in which a mass ratio ($M_{FB1}:M_{FB2}$) of a mass $M_{FB1}$ of the first fibrous material to a mass $M_{FB2}$ of the second fibrous material in the multilayer film is 50:50 to 80:20.

[7]. The pellicle film according to [5] or [6],
in which a total of a mass percentage of the first fibrous material in the multilayer film and a mass percentage of the second fibrous material in the multilayer film is 90 mass% or more.

[8]. The pellicle film according to any one of [5] to [7],

in which the pellicle film further includes a third pellicle film,
the second pellicle film, the first pellicle film, and the third pellicle film are stacked in this order,
the third pellicle film contains a third fibrous material having a length of 100 $\mu$m or more and less than 250 $\mu$m, and
the second fibrous material and the third fibrous material are the same or different from each other.

[9]. The pellicle film according to [8],
in which a mass ratio ($M_{FB1}:(M_{FB2} + M_{FB3})$) of a mass $M_{FB1}$ of the first fibrous material to a total mass $M_{FB2} + M_{FB3}$ of a mass $M_{FB2}$ of the second fibrous material and a mass $M_{FB3}$ of the third fibrous material in the multilayer film is 33:67 to 80:20.

[10]. The pellicle film according to [8] or [9],
in which a total of a mass percentage of the first fibrous material, a mass percentage of the second fibrous material, and a mass percentage of the third fibrous material in the multilayer film is 80 mass% or more.

[11]. The pellicle film according to any one of [1] to [10],
in which the length $L_{FB1}$ of the first fibrous material is in a range from 1 $\mu$m to 20 $\mu$m.

[12]. The pellicle film according to any one of [1] to [11],
in which the length $L_{FB2}$ of the second fibrous material is in a range from 100 $\mu$m to 200 $\mu$m.

[13]. The pellicle film according to any one of [1] to [12], in which the pellicle film has a self-standing property.

[14]. A pellicle including: the pellicle film according any one of [1] to [13]; and a support that has a frame and an opening surrounded by the frame and that supports the pellicle film.

According to an aspect of the invention, a pellicle film whose void characteristics are easily controlled and a pellicle including the pellicle film can be provided.

BRIEF DESCRIPTION OF DRAWINGS

Fig. 1 is a schematic cross-sectional view of a first example of a pellicle film according to a first exemplary embodiment.
Fig. 2 is a schematic cross-sectional view of a second example of the pellicle film according to the first exemplary embodiment.
Fig. 3 is a schematic cross-sectional view of a third example of the pellicle film according to the first exemplary embodiment.
Fig. 4 is a schematic cross-sectional view of a first example of a pellicle according to a second exemplary embodiment.
Fig. 5 is a schematic cross-sectional view of a second example of the pellicle according to the second exemplary embodiment.
Fig. 6 is a schematic cross-sectional view of a third example of the pellicle according to the second exemplary embodiment.
Fig. 7 is a scanning electron microscope image of a pellicle film according to an Example.

DESCRIPTION OF EMBODIMENT(S)

First Exemplary Embodiment

Pellicle Film

A pellicle film according to the exemplary embodiment contains a first fibrous material and a second fibrous material. A length $L_{FB1}$ of the first fibrous material contained in the pellicle film according to the exemplary embodiment is 20 $\mu$m or less, and a length $L_{FB2}$ of the second fibrous material is 100 $\mu$m or more and less than 250 $\mu$m.

Thus, the pellicle film according to the exemplary embodiment contains a plurality of types of fibrous materials that satisfy length ranges that are different from each other. If the length of the second fibrous material is 250 $\mu$m or more, the mass (or the molecular weight) per fiber of the second fibrous material is large. For example, when a pellicle film PF1 in which the length range of the fibrous material is 100 $\mu$m or more and less than 250 $\mu$m and a pellicle film PF2 in which the length range of the fibrous material is 250 $\mu$m or more are compared at the same fibrous material content in the pellicle films, the number of fibers of the fibrous material contained in the pellicle film PF2 is smaller than that of the pellicle film PF1, while the light transmittances of the pellicle film PF1 and the pellicle film PF2 are equal to each other. When the number of fibers of the fibrous material in the film decreases, the number of points at which fibers of the fibrous material are in contact with each other decreases, resulting in a decrease in the strength of the pellicle film. Therefore, it is required that the length of the second fibrous material be not excessively long.

The length of a fibrous material contained in the pellicle film corresponds to the length of the fibrous material used in the production of the pellicle film.

The length of the fibrous material used in the production of the pellicle film may be the nominal value disclosed by the manufacturer of the fibrous material.

Alternatively, the length of the fibrous material used in the production of the pellicle film can be measured as follows. A dispersion liquid in which the fibrous material is dispersed at a concentration of 0.001 mass% is cast on a solid substrate and then dried to cause the fibrous material to adhere to the solid substrate, and the fibrous material is observed with, for example, a microscope such as an atomic force microscope (AFM) or a scanning electron microscope (SEM). When the length is measured by observing the fibrous material with a microscope, preferably, 10 or more fibers of the fibrous material that are not bundled as much as possible are measured on a single solid substrate, and the average of the measured lengths is determined as the length of the fibrous material. The bundle refers to a fiber bundle constituted by a plurality of fibers of the fibrous material.

In the pellicle film according to the exemplary embodiment, from the viewpoints that the void characteristics of the pellicle film are easily controlled and that mechanical strength of the pellicle film is easily ensured, the length $L_{FB1}$ of the first fibrous material is preferably in a range from 1 $\mu$m to 20 $\mu$m, more preferably in a range from 1 $\mu$m to 10 $\mu$m.

In the pellicle film according to the exemplary embodiment, from the viewpoints that the void characteristics of the pellicle film are easily controlled and that optical transparency is easily controlled, the length $L_{FB2}$ of the second fibrous material is preferably in a range from 100 $\mu$m to 200 $\mu$m.

From the viewpoints of further improving the strength of the pellicle film and improving transparency of the pellicle film to exposure light, the pellicle film according to the exemplary embodiment preferably has a self-standing property. The pellicle film having a self-standing property means a pellicle film that is self-standing on its own and means that the pellicle film is a film having a self-supporting property (also referred to as a self-standing film). That is, a pellicle film having a self-standing property is a pellicle film that can retain its shape by itself even in the absence of a substrate, a reinforcing layer, and the like.

The first fibrous material and the second fibrous material contained in the pellicle film according to the exemplary embodiment are preferably each independently at least one fibrous material selected from the group consisting of cellulose-based fibrous materials, polymer-based fibrous materials, bio-based fibrous materials, carbon-based fibrous materials, silicon-based fibrous materials, boron-based fibrous materials, and metal-based fibrous materials. The first fibrous material and the second fibrous material may be the same type of material or different types of materials, but the first fibrous material and the second fibrous material are preferably the same type of material.

As specific examples of the fibrous materials contained in the pellicle film according to the exemplary embodiment, the cellulose-based fibrous materials are, for example, cellulose nanofibers; the polymer-based fibrous materials are, for example, fibrous materials containing a polymeric material such as polypropylene, polyethylene terephthalate, or polylactic acid; the bio-based fibrous materials are, for example, deoxyribonucleic acids (DNAs); the silicon-based fibrous materials are, for example, fibrous materials containing silicon carbide or silicon nitride or fibrous materials composed only of silicon atoms (silicon nanotubes); the carbon-based fibrous materials are, for example, carbon nanotubes (which may be abbreviated as CNTs), pitch-based carbon fibers, or PAN-based carbon fibers; the boron-based fibrous materials are, for example, fibrous materials containing boron nitride; and the metal-based fibrous materials are, for example, nanowires containing metal.

The first fibrous material and the second fibrous material contained in the pellicle film according to the exemplary embodiment are preferably each independently a carbon-based fibrous material (that is, a first carbon-based fibrous material and a second carbon-based fibrous material), more preferably carbon nanotubes (that is, first carbon nanotubes and second carbon nanotubes). In the pellicle film according to the exemplary embodiment, the first carbon-based fibrous material serving as the first fibrous material and the second carbon-based fibrous material serving as the second fibrous material may be different types of carbon-based fibrous materials, but are preferably the same type of carbon-based fibrous material.

The carbon nanotubes contained in the pellicle film according to the exemplary embodiment are not particularly limited, and are preferably at least one selected from the group consisting of multi-walled carbon nanotubes (MWCNT), few-walled carbon nanotubes (FWCNT), double-walled carbon nanotubes (DWCNT), and single-walled carbon nanotube (SWCNT). In the pellicle film according to the exemplary embodiment, the first carbon nanotubes serving as the first carbon-based fibrous material and the second carbon nanotubes serving as the second carbon-based fibrous material may be the same type of carbon nanotubes or different types of carbon nanotubes.

In the exemplary embodiment, the multi-walled carbon nanotubes are carbon nanotubes having, for example, in a range from 4 to 20 concentric layers and a diameter in a range from 4 nm to 100 nm. The few-walled carbon nanotubes are carbon nanotubes having, for example, 2 or 3 concentric layers and a diameter in a range from 2 nm to 8 nm. The single-walled carbon nanotube has, for example, a single layer and a tube diameter in a range from 0.2 nm to 5 nm.

In one aspect of the exemplary embodiment, the cross-sectional diameter of the carbon nanotubes is in a range from 0.2 nm to 50 nm.

In one aspect of the exemplary embodiment, the cross-sectional diameter of the carbon nanotubes is 0.5 nm or more, or 1 nm or more.

In one aspect of the exemplary embodiment, the cross-sectional diameter of the carbon nanotubes is 30 nm or less or 20 nm or less.

It is also preferable that, in the pellicle film according to the exemplary embodiment, the cross-sectional diameters of the first carbon nanotubes and the second carbon nanotubes each independently satisfy any of the ranges of the cross-sectional diameter described above.

The carbon nanotubes are obtained by a publicly known method and obtained by, for example, a chemical vapor deposition method, a laser ablation method, or an arc discharge method.

It is also preferable that the pellicle film according to the exemplary embodiment be substantially composed only of fibrous materials (preferably carbon-based fibrous materials, more preferably carbon nanotubes). Herein, the expression "substantially composed only of fibrous materials" means that fibrous materials (preferably carbon nanotubes) account for 98 mass% or more (preferably, 99 mass% or more, more preferably 99.9 mass% or more) in the pellicle film. In the case where the pellicle film is substantially composed only of fibrous materials (preferably carbon-based fibrous materials, more preferably carbon nanotubes), incidental impurities, which are substances that are not intentionally added to the pellicle film but are mixed in the raw materials or during the production process, may be contained in the pellicle film or are not necessarily contained in the pellicle film.

The pellicle film according to the exemplary embodiment may be a single-layer film or a multilayer film in which a plurality of layers are stacked.

Single-layer Film

When the pellicle film according to the exemplary embodiment is a single-layer film, the first fibrous material and the second fibrous material preferably coexist in the single-layer film. In the exemplary embodiment, surfaces on both sides of the single-layer film in which the first fibrous material and the second fibrous material coexist are preferably the outermost surfaces of the pellicle film.

In the pellicle film according to the exemplary embodiment, from the viewpoint that the void characteristics of the pellicle film are easily controlled, it is also preferable that a mass ratio ($M_{FB1}:M_{FB2}$) of a mass $M_{FB1}$ of the first fibrous material to a mass $M_{FB2}$ of the second fibrous material in the single-layer film be 5:95 to 95:5.

In the pellicle film according to the exemplary embodiment, from the viewpoint that the void characteristics of the pellicle film are easily controlled, it is also preferable that the mass ratio ($M_{FB1}:M_{FB2}$) of the mass $M_{FB1}$ of the first fibrous material to the mass $M_{FB2}$ of the second fibrous material in the single-layer film be 7:93 to 93:7.

In the pellicle film according to the exemplary embodiment, from the viewpoint that the void characteristics of the pellicle film are easily controlled, it is preferable that the mass ratio ($M_{FB1}:M_{FB2}$) of the mass $M_{FB1}$ of the first fibrous material to the mass $M_{FB2}$ of the second fibrous material in the single-layer film be 10:90 to 90:10.

In the pellicle film according to the exemplary embodiment, from the viewpoint that the void characteristics of the pellicle film are easily controlled, the mass ratio ($M_{FB1}:M_{FB2}$) of the mass $M_{FB1}$ of the first fibrous material to the mass $M_{FB2}$ of the second fibrous material in the single-layer film is preferably 5:95 to 45:55, 5:95 to 30:70, 5:95 to 20:80, or 5:95 to 15:85.

A mass percentage of the first fibrous material in the single-layer film represented by a numerical formula (Numerical Formula 11) below is preferably in a range from 10 mass% to 90 mass%.

$$\{M_{FB1}/(M_{FB1} + M_{FB2})\} \times 100 \cdots \text{(Numerical Formula 11)}$$

A mass percentage of the second fibrous material in the single-layer film represented by a numerical formula (Numerical Formula 12) below is preferably in a range from 10 mass% to 90 mass%.

$$\{M_{FB2}/(M_{FB1} + M_{FB2})\} \times 100 \cdots \text{(Numerical Formula 12)}$$

In the pellicle film according to the exemplary embodiment, from the viewpoint that the void characteristics are easily controlled, a total of the mass percentage of the first fibrous material in the single-layer film and the mass percentage of the second fibrous material in the single-layer film is preferably 90 mass% or more, more preferably 95 mass% or more, and still more preferably 98 mass% or more.

When the pellicle film according to the exemplary embodiment is a single-layer film, it is preferable that the single-layer film be substantially composed only of a first fibrous material (preferably a first carbon-based fibrous material, more preferably first carbon nanotubes) and a second fibrous material (preferably a second carbon-based fibrous material, more preferably second carbon nanotubes). Herein, the expression "substantially composed only of a first fibrous material and a second fibrous material" means that a first fibrous material (preferably a first carbon-based fibrous material, more preferably first carbon nanotubes) and a second fibrous material (preferably a second carbon-based fibrous material, more preferably second carbon nanotubes) account for 98 mass% or more (preferably, 99 mass% or more, more preferably 99.9 mass% or more) in the single-layer film. In the case where the pellicle film is substantially composed only of the first fibrous material and the second fibrous material, incidental impurities, which are substances that are not intentionally added to the pellicle film but are mixed in the raw materials or during the production process, may be contained in the pellicle film, but, preferably, no incidental impurities are contained.

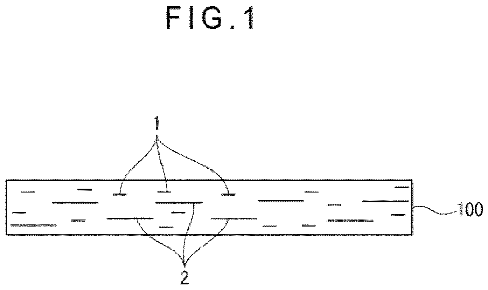

Fig. 1 is a schematic cross-sectional view of a first example of a pellicle film according to a first exemplary embodiment. The invention is not limited to the illustrated pellicle film. It should be noted that, in drawings for description with reference to the drawings in this specification, some portions are illustrated in enlarged or reduced size for simplicity of description.

A pellicle film 100 illustrated in Fig. 1 is a single-layer film. A first fibrous material 1 and a second fibrous material 2 coexist and are dispersed with each other in the pellicle film 100, which is a single-layer film. It should be noted that the fibrous materials illustrated in Figs. 1 to 6 are schematically illustrated, and the invention is not limited to the shapes, the numbers, the states, etc. of the illustrated fibrous materials. In the single-layer film, fibers of the first fibrous material 1 may be in contact with each other, fibers of the second fibrous material 2 may be in contact with each other, or fibers of the first fibrous material and fibers of the second fibrous material may be in contact with each other.

Multilayer Film

When the pellicle film according to the exemplary embodiment is a multilayer film, the pellicle film is preferably a multilayer film including a first pellicle film and a second pellicle film. The first pellicle film and the second pellicle film are preferably stacked. The first pellicle film and the second pellicle film are preferably in direct contact with each other. The first pellicle film preferably contains the first fibrous material, and the second pellicle film preferably contains the second fibrous material. In the exemplary embodiment, when the pellicle film is a multilayer film in which the first pellicle film and the second pellicle film are stacked, preferably, the first pellicle film is exposed on one outermost surface of the multilayer film, and the second pellicle film is exposed on the other outermost surface.

In the pellicle film according to the exemplary embodiment, from the viewpoint that the void characteristics are easily controlled, it is also preferable that a mass ratio ($M_{FB1}:M_{FB2}$) of a mass $M_{FB1}$ of the first fibrous material to a mass $M_{FB2}$ of the second fibrous material in the multilayer film be 45:55 to 85:15.

In the pellicle film according to the exemplary embodiment, from the viewpoint that the void characteristics are easily controlled, it is also preferable that the mass ratio ($M_{FB1}:M_{FB2}$) of the mass $M_{FB1}$ of the first fibrous material to the mass $M_{FB2}$ of the second fibrous material in the multilayer film be 48:52 to 82:18.

In the pellicle film according to the exemplary embodiment, from the viewpoint that the void characteristics are easily controlled, it is preferable that the mass ratio ($M_{FB1}:M_{FB2}$) of the mass $M_{FB1}$ of the first fibrous material to the mass $M_{FB2}$ of the second fibrous material in the multilayer film be 50:50 to 80:20.

From the viewpoint that the void characteristics are easily controlled, a mass percentage of the first fibrous material in the multilayer film represented by a numerical formula (Numerical Formula 21) below is preferably in a range from 50 mass% to 80 mass%.

$$\{M_{FB1}/(M_{FB1} + M_{FB2})\} \times 100 \cdots \text{(Numerical Formula 21)}$$

From the viewpoint that the void characteristics are easily controlled, a mass percentage of the second fibrous material in the multilayer film represented by a numerical formula (Numerical Formula 22) below is preferably in a range from 20 mass% to 50 mass%.

$$\{M_{FB2}/(M_{FB1} + M_{FB2})\} \times 100 \cdots \text{ (Numerical Formula 22)}$$

In the pellicle film according to the exemplary embodiment, from the viewpoint that the void characteristics are easily controlled, a total of the mass percentage of the first fibrous material in the multilayer film and the mass percentage of the second fibrous material in the multilayer film is preferably 90 mass% or more, more preferably 95 mass% or more, and still more preferably 98 mass% or more.

When the pellicle film according to the exemplary embodiment is a multilayer film, the pellicle film preferably further includes a third pellicle film containing a third fibrous material having a length of 100 $\mu$m or more and less than 250 $\mu$m. In this case, the second pellicle film, the first pellicle film, and the third pellicle film are preferably stacked in this order. In the exemplary embodiment, when the pellicle film is a multilayer film in which the second pellicle film, the first pellicle film, and the third pellicle film are stacked in this order, preferably, the second pellicle film is exposed on one outermost surface of the multilayer film, and the third pellicle film is exposed on the other outermost surface. By covering both surfaces of the first pellicle film containing the first fibrous material having a relatively short length with the second pellicle film containing the second fibrous material having a relatively long length and the third pellicle film containing the third fibrous material having a relatively long length, it is possible to expect the effect of reducing the possibility of the first fibrous material falling off from the pellicle film and becoming foreign matter during the manufacturing and use of the pellicle film.

If the length of the third fibrous material is 250 $\mu$m or more, the mass (or the molecular weight) per fiber of the third fibrous material is large as in the case of the second fibrous material. Accordingly, when the pellicle film PF1 in which the length range of the fibrous material is 100 $\mu$m or more and less than 250 $\mu$m and the pellicle film PF2 in which the length range of the fibrous material is 250 $\mu$m or more are compared at the same fibrous material content in the pellicle films, the number of fibers of the fibrous material contained in the pellicle film PF2 is smaller than that of the pellicle film PF1, while the light transmittances of the pellicle film PF1 and the pellicle film PF2 are equal to each other. When the number of fibers of the fibrous material in the film decreases, the number of points at which fibers of the fibrous material are in contact with each other decreases, resulting in a decrease in the strength of the pellicle film. Therefore, it is preferable that the length of the third fibrous material be not excessively long.

In the pellicle film according to the exemplary embodiment, from the viewpoints that the void characteristics of the pellicle film are easily controlled and that optical transparency is easily controlled, a length $L_{FB3}$ of the third fibrous material is preferably in a range from 100 $\mu$m to 200 $\mu$m.

The second fibrous material and the third fibrous material are not particularly limited as long as the fibrous materials have a length of 100 $\mu$m or more and less than 250 $\mu$m, and the second fibrous material and the third fibrous material may be the same or different from each other.

The third fibrous material contained in the pellicle film according to the exemplary embodiment is preferably a fibrous material selected from the group consisting of cellulose-based fibrous materials, polymer-based fibrous materials, bio-based fibrous materials, carbon-based fibrous materials, silicon-based fibrous materials, boron-based fibrous materials, and metal-based fibrous materials, and specific examples of these fibrous materials are the same as those described above. The first fibrous material, the second fibrous material, and the third fibrous material may be the same type of material or different types of materials, but the first fibrous material, the second fibrous material, and the third fibrous material are preferably the same type of material.

The third fibrous material contained in the pellicle film according to the exemplary embodiment is preferably a carbon-based fibrous material (that is, a third carbon-based fibrous material), more preferably carbon nanotubes (that is, third carbon nanotubes). In the pellicle film according to the exemplary embodiment, the second carbon-based fibrous material serving as the second fibrous material and the third carbon-based fibrous material serving as the third fibrous material may be different types of carbon-based fibrous materials, but are preferably the same type of carbon-based fibrous material. In the pellicle film according to the exemplary embodiment, the second carbon nanotubes serving as the second carbon-based fibrous material and the third carbon nanotubes serving as the third carbon-based fibrous material may be the same type of carbon nanotubes or different types of carbon nanotubes. For example, in the second carbon nanotubes and the third carbon nanotubes, the numbers of layers constituting the carbon nanotubes may be the same or different from each other. For example, the second carbon nanotubes may be used in the third pellicle film as the third carbon nanotubes.

When the pellicle film according to the exemplary embodiment is a multilayer film including the first, second, and third pellicle films, from the viewpoint that the void characteristics of the pellicle film are easily controlled, it is preferable that a mass ratio ($M_{FB1}:(M_{FB2} + M_{FB3})$) of a mass $M_{FB1}$ of the first fibrous material to a total mass $M_{FB2} + M_{FB3}$ of a mass $M_{FB2}$ of the second fibrous material and a mass $M_{FB3}$ of the third fibrous material in the multilayer film be 33:67 to 80:20.

When the pellicle film according to the exemplary embodiment is a multilayer film including the first, second, and third pellicle films, it is also preferable that the mass ratio ($M_{FB1}:(M_{FB2} + M_{FB3})$) be 20:80 to 80:20, 25:75 to 75:25, 30:70 to 70:30, 30:70 to 60:40, 30:70 to 50:50, or 30:70 to 40:60.

When the pellicle film according to the exemplary embodiment is a multilayer film including the first pellicle film, the second pellicle film, and the third pellicle film, from the viewpoint that the void characteristics of the pellicle film are easily controlled, a total of a mass percentage of the first fibrous material, a mass percentage of the second fibrous material, and a mass percentage of the third fibrous material in the multilayer film is preferably 80 mass% or more, more preferably 90 mass% or more, still more preferably 95 mass% or more, and still further more preferably 98 mass% or more.

When the pellicle film according to the exemplary embodiment is a multilayer film, it is preferable that the first pellicle film constituting the multilayer film be substantially composed only of a first fibrous material (preferably a first carbon-based fibrous material, more preferably first carbon nanotubes), the second pellicle film be substantially composed only of a second fibrous material (preferably a second carbon-based fibrous material, more preferably second carbon nanotubes), and the third pellicle film be substantially composed only of a third fibrous material (preferably a third carbon-based fibrous material, more preferably third carbon nanotubes). Herein, the expression "substantially composed only of a first, second, or third fibrous material" means that the first, second, or third fibrous material accounts for 98 mass% or more (preferably, 99 mass% or more, more preferably 99.9 mass% or more) in the first, second, or third pellicle film. In the case where the first, second, or third pellicle film is substantially composed only of the first, second, or third fibrous material, incidental impurities, which are substances that are not intentionally added to the pellicle film but are mixed in the raw materials or during the production process, may be contained in the pellicle film or are not necessarily contained in the pellicle film.

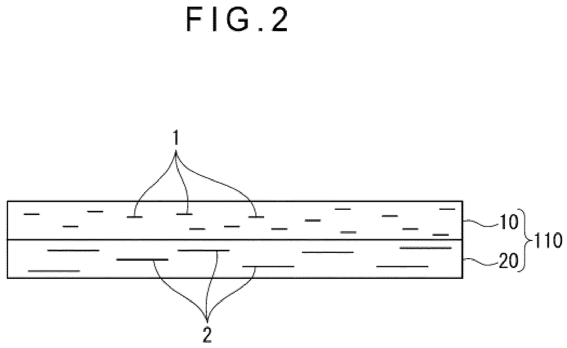

Fig. 2 is a schematic cross-sectional view of a second example of the pellicle film according to the first exemplary embodiment. A pellicle film 110 illustrated in Fig. 2 is a multilayer film in which a first pellicle film 10 containing the first fibrous material 1 and a second pellicle film 20 containing the second fibrous material 2 are stacked.

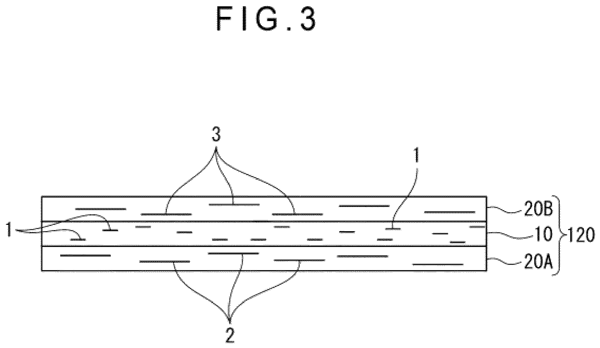

Fig. 3 is a schematic cross-sectional view of a third example of the pellicle film according to the first exemplary embodiment. A pellicle film 120 illustrated in Fig. 3 is a multilayer film in which the first pellicle film 10 containing the first fibrous material 1, a second pellicle film 20A containing the second fibrous material 2, and a third pellicle film 20B containing a third fibrous material 3 are stacked.

In the pellicle film according to the exemplary embodiment, the fibrous materials (such as the first, second, and third fibrous materials) are each preferably oriented in a direction along a surface of the pellicle film (in-plane direction). That is, the long-axis direction of each of the fibrous materials (such as the first, second, and third fibrous materials) is preferably the same direction as the in-plane direction of the pellicle film.

The thickness of the entire pellicle film (if the pellicle film is a single-layer film, it means the entire single-layer film, and if the pellicle film is a multilayer film, it means the entire multilayer film) according to the exemplary embodiment is not particularly limited and is preferably in a range from 3 nm to 1,000 nm. The thickness of the entire pellicle film is preferably 10 nm or more, more preferably 20 nm or more, and still more preferably 30 nm or more. The thickness of the entire pellicle film is preferably 600 nm or less, more preferably 300 nm or less. When the thickness of the entire pellicle film is, for example, in a range from 3 nm to 1,000 nm, the strength of the pellicle film is further improved, and EUV transmissivity is easily ensured.

When the pellicle film according to the exemplary embodiment is a multilayer film including a first pellicle film, a second pellicle film, and a third pellicle film, the thicknesses of the first pellicle film, the second pellicle film, and the third pellicle film are each independently preferably in a range from 3 nm to 200 nm, more preferably in a range from 10 nm to 200 nm.

The mass per unit area of the entire pellicle film is not particularly limited and is preferably in a range from 1 ng/mm$^2$ to 30 ng/mm$^2$. The mass per unit area of the entire pellicle film is preferably 2 ng/mm$^2$ or more, more preferably 4 ng/mm$^2$ or more. The mass per unit area of the entire pellicle film is preferably 20 ng/mm$^2$ or less, more preferably 10 ng/mm$^2$ or less. When the mass per unit area of the entire pellicle film is, for example, in a range from 1 ng/mm$^2$ to 30 ng/mm$^2$ (more preferably in a range from 2 ng/mm$^2$ to 20 ng/mm$^2$, still more preferably in a range from 4 ng/mm$^2$ to 10 ng/mm$^2$), the strength of the pellicle film is further improved, and EUV transmissivity is easily ensured.

The pellicle film according to the exemplary embodiment is preferably a porous structural body formed by deposition of a fibrous material. Such a porous structural body formed by deposition of a fibrous material can be produced by an example of a preferred method for producing a pellicle film described later. When the pellicle film is a porous structural body formed by deposition of a fibrous material, the strength of the pellicle film is further improved, and a variation in EUV transmissivity is more likely to be reduced.

Method for Producing Pellicle Film

The method for producing a pellicle film is not particularly limited and may be appropriately selected according to the materials used.

An example of a preferred method for producing a pellicle film containing a fibrous material includes, for example, a step (PE1) of dispersing a fibrous material, a step (PE2) of precipitating and depositing the dispersed fibrous material on an air-permeable member to obtain a fibrous material film product formed in mat form on the air-permeable member, and a step (PE3) of removing the air-permeable member from the fibrous material film product to obtain a pellicle film.

Step PE1

First, in the step PE1, a fibrous material is dispersed in a liquid to prepare a fibrous material dispersion liquid in which the fibrous material is dispersed in the liquid. The liquid may be a liquid containing water. The fibrous material dispersion liquid may contain only the fibrous material as a solute, or may contain, in addition to the fibrous material, various additives such as a dispersant for dispersing the fibrous material. The dispersant is, for example, carboxymethyl cellulose or sodium taurodeoxycholate.

Hereinafter, the fibrous material dispersion liquid may be referred to as an FB dispersion liquid, and a carbon nanotube dispersion liquid in a case of using carbon nanotubes as the fibrous material may be referred to as a CNT dispersion liquid.

In a case of producing a pellicle film in which a first fibrous material and a second fibrous material coexist, the step PE1 preferably includes a step (PE11) of dispersing the first fibrous material in a first liquid to prepare a first dispersion liquid, a step (PE12) of dispersing the second fibrous material in a second liquid to prepare a second dispersion liquid, and a step (PE13) of mixing and stirring the first dispersion liquid and the second dispersion liquid to prepare a mixed fibrous material dispersion liquid. Hereinafter, the mixed fibrous material dispersion liquid may be referred to as a mixed FB dispersion liquid, and a mixed carbon nanotube dispersion liquid in a case of using carbon nanotubes as the fibrous materials may be referred to as a mixed CNT dispersion liquid. The first liquid and the second liquid may be the same liquid or different liquids; however, from the viewpoint of the ease of mixing, the first liquid and the second liquid are preferably the same liquid, and both may be liquids containing water.

In a case of producing a multilayer film in which a first pellicle film containing a first fibrous material and a second pellicle film containing a second fibrous material are stacked, the step PE1 preferably includes the step PE11 and the step PE12 described above.

In a case of producing a multilayer film in which a first pellicle film, a second pellicle film, and a third pellicle film containing a third fibrous material are stacked, the step PE1 preferably includes, in addition to the step PE11 and the step PE12 described above, a step (PE14) of dispersing the third fibrous material in a third liquid to prepare a third dispersion liquid. The first liquid, the second liquid, and the third liquid may be the same liquid or different liquids. From the viewpoint of the ease of preparation of the dispersion liquids, the first liquid, the second liquid, and the third liquid are preferably the same liquid, and all of these liquids may be liquids containing water.

Step PE2

Next, in the step PE2, the dispersed fibrous material is precipitated and deposited on an air-permeable member. For example, the FB dispersion liquid prepared in the step PE1 is filtered through a filtration membrane serving as the air-permeable member, so that the fibrous material is precipitated and deposited to form a fibrous material film product formed in mat form on the filtration membrane. As the filtration membrane, for example, a membrane filter or the like is preferably used.

In a case of producing a pellicle film in which a first fibrous material and a second fibrous material coexist, the step PE2 preferably includes a step (PE21) of forming a film product using the mixed FB dispersion liquid prepared in the step PE13 described above.

In a case of producing a multilayer film in which a first pellicle film and a second pellicle film are stacked, the step PE2 preferably includes a step (PE22) of forming a first film product using one of the first dispersion liquid and the second dispersion liquid and a step (PE23) of forming a second film product using the other one of the first dispersion liquid and the second dispersion liquid on the first film product that has been previously formed to form a laminate of the first film product and the second film product.

In a case of producing a multilayer film in which a first pellicle film, a second pellicle film, and a third pellicle film are stacked, the step PE2 preferably includes a step (PE24) of forming a third film product using one of the second dispersion liquid and the third dispersion liquid, a step (PE25) of forming a fourth film product using the first dispersion liquid, and a step (PE26) of forming a fifth film product using the other one of the second dispersion liquid and the third dispersion liquid to form a laminate of the third film product, the fourth film product, and the fifth film product.

Step PE3

Next, in the step PE3, the filtration membrane is removed from the fibrous material film product formed in mat form to obtain a pellicle film including the fibrous material. A drying step may be performed as necessary before the filtration membrane is removed from the fibrous material film product formed in mat form or after the filtration membrane is removed from the fibrous material film product formed in mat form.

According to the pellicle film according to the exemplary embodiment, void characteristics (for example, a void diameter and an aperture ratio) are easily controlled. Void characteristics tend to affect foreign matter capturing performance and EUV transmissivity. Therefore, use of the pellicle film according to the exemplary embodiment easily provides a pellicle that combines foreign matter capturing performance and EUV transmissivity in a balanced manner.

The pellicle film according to the exemplary embodiment includes a first fibrous material and a second fibrous material having different lengths. According to the exemplary embodiment, a pellicle film having a small maximum pore diameter (mesh defect) can be provided in any compositional ratio of the fibrous materials compared with a pellicle film composed of a single type of fibrous material.

When the pellicle film according to the exemplary embodiment is a single-layer film, the first fibrous material and the second fibrous material having different lengths are dispersed in the single-layer film; therefore, the mesh structure is uniformized, and the sudden occurrence of non-uniform shapes (defects) can be inhibited.

Furthermore, according to the exemplary embodiment, an average pore diameter of the pellicle film can be controlled by adjusting the mass ratio of the first fibrous material having a short length and the second fibrous material having a long length in the single-layer film. The higher the proportion of the first fibrous material, the smaller the average pore diameter. The higher the proportion of the second fibrous material, the larger the average pore diameter.

Furthermore, when the pellicle film according to the exemplary embodiment is a single-layer film having a self-standing property, a change in the mesh structure in the thickness direction of the pellicle film is inhibited, and a pellicle film having a uniform mesh structure can be obtained.

When the pellicle film according to the exemplary embodiment is a single-layer film, the film formation process of the single-layer film is simple and highly productive compared with that of a multilayer film. For example, when a pellicle film is formed by filtration, a single-layer film can be formed by a single filtration operation, whereas a multilayer film is formed by multiple filtration operations.

When the pellicle film according to the exemplary embodiment is a multilayer film having a self-standing property, the first pellicle film containing the first fibrous material having a short length, which ensures the film strength, is formed; therefore, a decrease in the film strength is inhibited even when the second pellicle film containing the second fibrous material having a long length is combined. When pellicle films having the same fibrous material content in the film are compared, a pellicle film having a higher content of the first fibrous material having a short length in the film tends to have higher film strength.

Furthermore, when the pellicle film according to the exemplary embodiment is a multilayer film having a self-standing property, a mesh structure (pore size) having a distribution in the thickness direction of the multilayer film can be obtained. Thus, a multilayer film that combines the features of the first pellicle film and second pellicle film can be provided.

Furthermore, since the pellicle film according to the exemplary embodiment contains the first fibrous material and the second fibrous material that have lengths within predetermined ranges, the aperture ratio of voids of the pellicle film can be controlled in a certain range in any compositional ratio of the fibrous materials.

Herein, the aperture ratio of voids means a ratio of the sum of the areas of void portions per unit area of the surface of a pellicle film. The aperture ratio is expressed as a percentage. In the pellicle film, the aperture ratio relates to the light transmittance of the film. The larger the aperture ratio, the larger the light transmittance of the film tends to be.

Herein, the void diameter means a diameter of an imaginary circle having the same area as the area of a void (that is, an equivalent circle diameter).

Regarding the void characteristics measured at a surface of the porous structure of the pellicle film, void characteristics of the aperture ratio and an average void diameter may be measured by a method including steps (1) to (10) described below. A unique threshold is determined by employing the measurement method described below; therefore, plausible results are likely to be obtained regardless of the measurer. The method for measuring the void characteristics is, specifically, as described in Examples below.

(1) A step of preparing a pellicle film.

(2) A step of capturing an image of a surface of the prepared pellicle film to acquire image data of the pellicle film.

(3) A step of setting a plurality of different thresholds of three or more as initial thresholds at equal intervals in a range from a first pixel value to a second pixel value larger than the first pixel value and performing binarization processing on the image data on the basis of each of the initial thresholds to acquire binarized image data based on the initial thresholds.

(4) A step of performing blob analysis on the binarized image data based on the initial thresholds to thereby obtain an initial actual value calculated as a distribution of void characteristics of voids in the surface of the pellicle film.

(5) A step of determining, on the basis of the initial actual value, an initial theoretical value of the distribution of void characteristics that is determined by a probability density function of a log-normal distribution.

(6) A step of determining a difference between the initial actual value and the initial theoretical value.

(7) A step of, if the difference between the initial actual value and the initial theoretical value is not minimal, resetting a threshold, performing binarization processing on the image data on the basis of the reset threshold to acquire binarized image data based on the reset threshold, and performing blob analysis on the binarized image data based on the reset threshold to thereby obtain a remeasured actual value calculated as a distribution of void characteristics of voids in the surface of the pellicle film.

(8) A step of determining, on the basis of the remeasured actual value, a difference from a remeasured theoretical value of the distribution of void characteristics that is determined by a probability density function of a log-normal distribution.

(9) A step of, if the difference between the remeasured actual value and the remeasured theoretical value is not minimal, repeating the step of obtaining a remeasured actual value and the step of determining a difference from a remeasured theoretical value until the difference between the remeasured actual value and the remeasured theoretical value becomes minimal.

(10) A step of obtaining, as a final actual value, a distribution of void characteristics calculated on the basis of a threshold at which the difference between the initial actual value and the initial theoretical value or the difference between the remeasured actual value and the remeasured theoretical value is minimal.

The threshold at which the difference is minimal is preferably determined by using various publicly known optimization algorithms. For example, a threshold at which the above-described difference is minimal is preferably searched using various publicly known optimization algorithms in the above steps (4) to (9). In this case, after the determination of the initial thresholds, the unique threshold is determined by using the optimization algorithms.

In the step of acquiring binarized image data based on the initial thresholds, the initial thresholds are not limited to the above, and a plurality of different thresholds of five or more may be set at equal intervals in a range from a first pixel value to a second pixel value larger than the first pixel value, or a plurality of different thresholds of seven or more may be set. The interval between the first pixel value and the second pixel value is preferably 100 or more. The first pixel value is preferably set in a range from 20 to 50. The second pixel value is preferably set in a range from 150 to 240. Equal intervals mean that intervals between adjacent thresholds are equal to each other: for example, when n thresholds are set as the plurality of different thresholds of three or more, both the interval between the n-th threshold and the (n - 1)th threshold and the interval between the (n - 1)th threshold and the (n - 2)th threshold are equal to each other. As for the initial thresholds, specifically, for example, a plurality of different thresholds in a range from 3 to 12 can be set as the initial thresholds at equal intervals within a range from a pixel value of 20 to a pixel value of 240.

It should be noted that, in the step of obtaining a remeasured actual value, the threshold to be reset is not the plurality of different thresholds of three or more but one threshold.

The void characteristics may be measured with, for example, an apparatus that includes a program causing a computer to execute the above steps (1) to (10). The program may be recorded on a recording medium.

Second Exemplary Embodiment

Next, the configuration of a pellicle according to a second exemplary embodiment will be described. In the description of the second exemplary embodiment, the same components as those in the first exemplary embodiment are, for example, denoted by the same reference signs or names to omit or simplify an explanation of the components. In the second exemplary embodiment, structures, materials, and the like that are not specified may be the same as the structures, materials, and the like described in the first exemplary embodiment.

Pellicle

A pellicle according to the exemplary embodiment includes the pellicle film according to the first exemplary embodiment and a support.

Support

The support supports the pellicle film. The support has a frame and an opening surrounded by the frame. The frame has a support surface that supports the pellicle film. The opening passes through the support from one surface to the other surface. The frame and the opening are each formed in a rectangular shape. In the exemplary embodiment, four corners of the external shape of the frame are each rounded, but the shape of the frame is not limited to this shape. Publicly known materials can be used as the material of the support, and examples thereof include resin materials (such as polyethylene), metal materials (such as aluminum, aluminum alloys, magnesium alloys, stainless steel, titanium, titanium alloys, and Invar), ceramic materials (such as SiC and SiN), quartz, and fiber-reinforced plastic materials (such as carbon fiber-reinforced plastics and glass fiber-reinforced plastics).

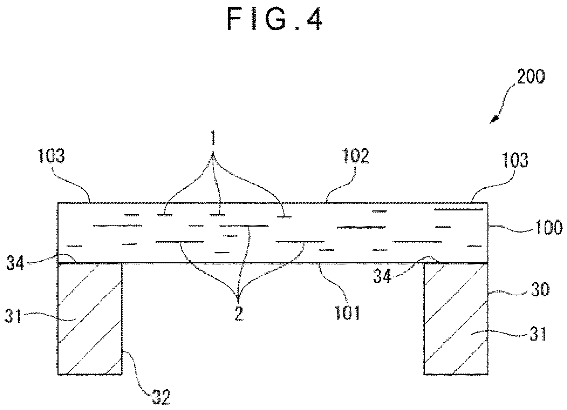

Figs. 4, 5, and 6 are schematic cross-sectional views of a first example, a second example, and a third example, respectively, of the pellicle according to the second exemplary embodiment. The invention is not limited to the illustrated pellicles. It should be noted that, in drawings for description with reference to the drawings in this specification, some portions are illustrated in enlarged or reduced size for simplicity of description.

A pellicle 200 illustrated in Fig. 4 includes the pellicle film 100 according to the first exemplary embodiment and a support 30. The pellicle film 100 has a first pellicle film surface 101 and a second pellicle film surface 102 opposite to the first pellicle film surface 101. The support 30 has a frame 31 and an opening 32 surrounded by the frame 31. The frame 31 has a support surface 34 that faces the pellicle film 100. Specifically, the support surface 34 faces the first pellicle film surface 101 of the pellicle film 100 when supporting the pellicle film 100. The opening 32 passes through the support 30 from one surface to the other surface. The frame 31 and the opening 32 are each formed in a rectangular shape. In the pellicle 200, a first pellicle film surface 101 side of a peripheral portion 103 of the pellicle film 100 is bonded or fixed to the support surface 34 of the frame 31, so that the pellicle film 100 covers the opening 32.

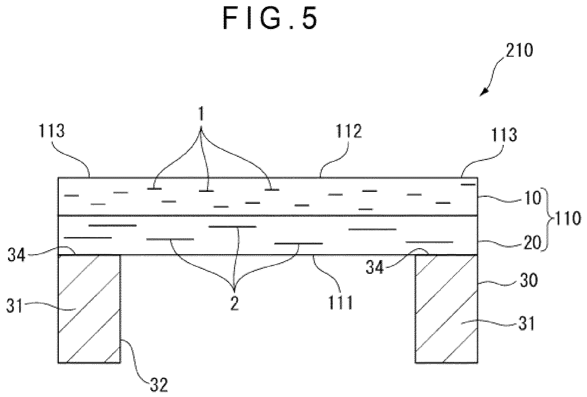

A pellicle 210 illustrated in Fig. 5 includes the pellicle film 110 according to the first exemplary embodiment and the support 30. The pellicle film 110 has a first pellicle film surface 111 and a second pellicle film surface 112 opposite to the first pellicle film surface 111. In the pellicle 210, a first pellicle film surface 111 side (that is, the second pellicle film 20) of a peripheral portion 113 of the pellicle film 110 is bonded or fixed to the support surface 34 of the frame 31.

Another example of the pellicle according to the second exemplary embodiment may be a pellicle in which a second pellicle film surface 112 side (that is, the first pellicle film 10) of the pellicle film 110 is bonded or fixed to the support surface 34 of the frame of the support 30.

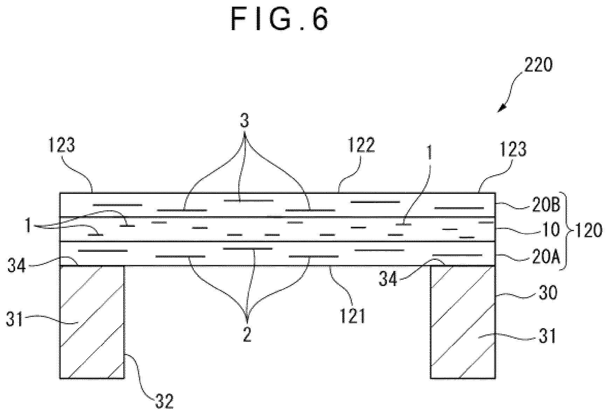

A pellicle 220 illustrated in Fig. 6 includes the pellicle film 120 according to the first exemplary embodiment and the support 30. The pellicle film 120 has a first pellicle film surface 121 and a second pellicle film surface 122 opposite to the first pellicle film surface 121. In the pellicle 220, a first pellicle film surface 121 side (that is, the second pellicle film 20A) of a peripheral portion 123 of the pellicle film 120 is bonded or fixed to the support surface 34 of the frame 31.

Another example of the pellicle according to the second exemplary embodiment may be a pellicle in which a second pellicle film surface 122 side (that is, the third pellicle film 20B) of the pellicle film 120 is bonded or fixed to the support surface 34 of the frame of the support 30.

Method for Producing Pellicle

Next, a method for producing a pellicle according to the second exemplary embodiment (hereinafter, also referred to as a production method of the second exemplary embodiment) will be described.

An example of the production method of the second exemplary embodiment includes a step (P1) of preparing a pellicle film according to the first exemplary embodiment, a step (P2) of preparing a support that has a frame and an opening surrounded by the frame and that supports the pellicle film, and a step (P3) of providing the pellicle film on the support such that the pellicle film covers the opening and is supported by a support surface of the frame. If necessary, the production method may include a step (P4) of providing a bonding layer on at least a portion of the support surface of the frame.

In the step (P1) of preparing a pellicle film, a pellicle film according to the first exemplary embodiment only needs to be prepared. In the step (P2) of preparing a support, a support formed in a desired shape only needs to be prepared by a publicly known method using any of the above-described materials constituting the support. In the step (P3) of providing the pellicle film, the pellicle film only needs to be disposed by a publicly known method such that the pellicle film covers the opening and is supported by the support surface of the frame. When a bonding layer is provided on at least a portion of the support surface of the frame, the pellicle film is disposed so as to be supported by the support surface of the frame with the bonding layer therebetween. When an adhesive is used for the bonding layer, in the step of providing the bonding layer, the adhesive is applied to the support surface to thereby provide the bonding layer including the adhesive. When a fibrous material is used for the bonding layer, in the step of providing the bonding layer, for example, a dispersion liquid of the fibrous material is applied to the support surface and dried to thereby provide the bonding layer including the fibrous material.

The pellicle according to the exemplary embodiment is used, for example, while being disposed above a photomask to be spaced apart from the photomask such that the first pellicle film surface faces the photomask.

The pellicle according to the exemplary embodiment includes the pellicle film according to the first exemplary embodiment. Thus, the exemplary embodiment can provide a pellicle whose void characteristics (for example, the void diameter and the aperture ratio) are controlled.

Modifications of Exemplary Embodiments

The invention is not limited to the above exemplary embodiments and includes any of modifications, improvements, and the like as long as the object of the invention can be achieved.

Examples of the pellicle film according to the first exemplary embodiment and examples of the pellicle according to the second exemplary embodiment have been described with reference to Figs. 1 to 6; however, the pellicle film and the pellicle according to the invention are not limited to these examples of the exemplary embodiments.

The pellicle according to the invention may employ any form as long as the advantageous effects of the pellicle film according to the first exemplary embodiment and the pellicle according to the second exemplary embodiment are achieved. The shapes, dimensions, etc., of portions of the members constituting the pellicle film according to the first exemplary embodiment and the pellicle according to the second exemplary embodiment can be determined according to, for example, the dimensions of a photomask (not illustrated) for which the pellicle according to the second exemplary embodiment is used.

For example, the shape of the pellicle film bonded to a support is often rectangular. The shape of the pellicle film according to the invention is not limited to a rectangular shape, and the pellicle film may be formed in any desired shape (for example, the shape of a photomask or the like) such as a circular, elliptical, or polygonal shape.

For example, a pellicle film which is a multilayer film may include a fourth pellicle film containing a fourth fibrous material having a length of 20 $\mu$m or less (preferably in a range from 1 $\mu$m to 20 $\mu$m). In this case, the first pellicle film, the second pellicle film, and the fourth pellicle film are preferably stacked in this order. The first fibrous material and the fourth fibrous material are not particularly limited as long as the fibrous materials have a length in a range from 1 $\mu$m to 20 $\mu$m, and the first fibrous material and the fourth fibrous material may be the same or different from each other. The fourth fibrous material is preferably a fibrous material selected from the group consisting of cellulose-based fibrous materials, polymer-based fibrous materials, bio-based fibrous materials, carbon-based fibrous materials, silicon-based fibrous materials, boron-based fibrous materials, and metal-based fibrous materials, and specific examples of these fibrous materials are the same as those described above. The first fibrous material, the second fibrous material, and the fourth fibrous material may be the same type of material or different types of materials, but the first fibrous material, the second fibrous material, and the fourth fibrous material are preferably the same type of material. The fourth fibrous material is preferably a carbon-based fibrous material (that is, a fourth carbon-based fibrous material), more preferably carbon nanotubes (that is, fourth carbon nanotubes). For example, the first carbon-based fibrous material serving as the first fibrous material and the fourth carbon-based fibrous material serving as the fourth fibrous material may be different types of carbon-based fibrous materials, but are preferably the same type of carbon-based fibrous material. The first carbon nanotubes serving as the first carbon-based fibrous material and the fourth carbon nanotubes serving as the fourth carbon-based fibrous material may be the same type of carbon nanotubes or different types of carbon nanotubes. For example, in the first carbon nanotubes and the fourth carbon nanotubes, the number of layers constituting the carbon nanotubes may be the same or different from each other.

When the pellicle film is a multilayer film, it is also preferable that the number of pellicle films be 2 or 3 as in the exemplary embodiments described above, but the pellicle film may be a multilayer film composed of four or more films. For the pellicle films constituting the multilayer film, films containing fibrous materials having a long length and films containing fibrous materials having a short length can be combined according to desired characteristics.

For example, at least one of the first pellicle film that is substantially composed only of the first fibrous material or the second pellicle film that is substantially composed only of the second fibrous material may be stacked on one surface or both surfaces of the above-described single-layer film in which the first fibrous material and the second fibrous material coexist.

Alternatively, for example, the above-described single-layer film in which the first fibrous material and the second fibrous material coexist may be stacked on one surface or both surfaces of at least one of the first pellicle film that is substantially composed only of the first fibrous material or the second pellicle film that is substantially composed only of the second fibrous material.

As used herein, the terms "first", "second", "third", "fourth", "fifth", and the like are merely given to distinguish the components given these terms and do not limit the order and the like of the components unless otherwise stated. Herein, a numerical range expressed using "to" means a range including values before and after "to".

Examples

The invention will be more specifically described below with reference to Examples. The invention is not limited to these Examples.

Example 1

In Example 1, carbon nanotubes were used as fibrous materials.

First, a first dispersion liquid in which first carbon nanotubes were dispersed in water and a second dispersion liquid in which second carbon nanotubes were dispersed in water were prepared. The first carbon nanotubes had a length in a range from 1 $\mu$m to 20 $\mu$m and an aspect ratio in a range from 1,000 to 15,000, and the second carbon nanotubes had a length of 100 $\mu$m or more and less than 250 $\mu$m and an aspect ratio in a range from 10,000 to 300,000. The first dispersion liquid and the second dispersion liquid each contained carboxymethyl cellulose as a dispersant. In each of the first dispersion liquid and the second dispersion liquid, the concentration of the carbon nanotubes was 0.1 mass ppm, and the concentration of the dispersant was 10 mass ppm.

Next, the first dispersion liquid and the second dispersion liquid were mixed and stirred to prepare a mixed CNT dispersion liquid. The mass ratio of the first carbon nanotubes to the second carbon nanotubes in the mixed CNT dispersion liquid was 90:10.

Next, the mixed CNT dispersion liquid was filtered through a membrane filter to form, on the membrane filter, a circular pellicle film having a size with a diameter of 2 mm (2 mm$\Phi$). The mass per unit area of the entire pellicle film, which was an amount of carbon nanotubes (a total amount of the first carbon nanotubes and the second carbon nanotubes) in the pellicle film, was 1.0 $\mu$g/cm$^2$ (10 ng/mm$^2$).

Next, the whole membrane filter with the pellicle film was submerged in water to isolate the pellicle film on the water surface.

The isolated pellicle film was dried to obtain a pellicle film (single-layer film) according to Example 1.

Example 2

A pellicle film (single-layer film) according to Example 2 was obtained by forming a film in the same manner as in Example 1 except that the mixed CNT dispersion liquid was prepared such that the mass ratio of the first carbon nanotubes to the second carbon nanotubes was 50:50.

Example 3

A pellicle film (single-layer film) according to Example 3 was obtained by forming a film in the same manner as in Example 1 except that the mixed CNT dispersion liquid was prepared such that the mass ratio of the first carbon nanotubes to the second carbon nanotubes was 10:90.

Example 4

First, the same second dispersion liquid as in Example 1 was filtered through a membrane filter to form, on the membrane filter, a circular second pellicle film having a size with a diameter of 2 mm (2 mm$\Phi$).

Next, the same first dispersion liquid as in Example 1 was poured from above the second pellicle film and filtered to form, on the second pellicle film, a first pellicle film having approximately the same shape and size as the second pellicle film.

Next, the whole membrane filter with a pellicle film in which the first pellicle film and the second pellicle film were stacked was submerged in water to isolate the pellicle film on the water surface.

The isolated pellicle film was dried to obtain a pellicle film (multilayer film) according to Example 4. The mass per unit area of the entire pellicle film, which was an amount of carbon nanotubes (a total amount of the first carbon nanotubes and the second carbon nanotubes) in the pellicle film (multilayer film) according to Example 4, was 1.0 $\mu$g/cm$^2$ (10 ng/mm$^2$), and the mass ratio of the first carbon nanotubes to the second carbon nanotubes was 80:20.

Example 5

A pellicle film (multilayer film) according to Example 5 was obtained by forming a film in the same manner as in Example 4 except that the mass ratio of the first carbon nanotubes to the second carbon nanotubes in the multilayer film was 50:50.

Example 6

A pellicle film (multilayer film) according to Example 6 was obtained by forming a film in the same manner as in Example 5 except that the mass per unit area of the entire pellicle film, which was an amount of carbon nanotubes (a total amount of the first carbon nanotubes and the second carbon nanotubes) in the multilayer film was 0.8 $\mu$g/cm$^2$ (8 ng/mm$^2$).

Example 7

A pellicle film (multilayer film) according to Example 7 was obtained by forming a film in the same manner as in Example 5 except that a first pellicle film was first formed on a membrane filter using the first dispersion liquid, and a second pellicle film having approximately the same shape and size as the first pellicle film was subsequently formed on the first pellicle film using the second dispersion liquid.

Example 8

First, the same second dispersion liquid as in Example 1 was filtered through a membrane filter to form, on the membrane filter, a circular second pellicle film having a size with a diameter of 2 mm (2 mmΦ).
Next, the same first dispersion liquid as in Example 1 was poured and filtered to form, on the second pellicle film, a first pellicle film having approximately the same shape and size as the second pellicle film.
Next, the same second dispersion liquid as in Example 1 was poured as a third dispersion liquid and filtered to form, on the first pellicle film, a third pellicle film having approximately the same shape and size as the first pellicle film.
Next, the whole membrane filter with a pellicle film in which the second pellicle film, the first pellicle film, and the third pellicle film were stacked in this order was submerged in water to isolate the pellicle film on the water surface.
The isolated pellicle film was dried to obtain a pellicle film (multilayer film) according to Example 8. The mass per unit area of the entire pellicle film, which was an amount of carbon nanotubes (a total amount of the first carbon nanotubes, the second carbon nanotubes, and third carbon nanotubes) in the pellicle film (multilayer film) according to Example 8, was 1.0 $\mu$g/cm$^2$ (10 ng/mm$^2$), and the mass ratio of the first carbon nanotubes, the second carbon nanotubes, and the third carbon nanotubes was 33:33:33 (= 1:1:1).

Reference Example 1

First, the same first dispersion liquid as in Example 1 was filtered through a membrane filter to form, on the membrane filter, a circular first pellicle film having a size with a diameter of 2 mm (2 mmΦ). The amount of carbon nanotubes (the amount of the first carbon nanotubes) in the resulting pellicle film was 1.0 $\mu$g/cm$^2$ (10 ng/mm$^2$). Next, the whole membrane filter with the pellicle film was submerged in water to isolate the pellicle film on the water surface. The isolated pellicle film was dried to obtain a pellicle film (single-layer film) according to Reference Example 1.

Comparative Example 1

A pellicle film (single-layer film) according to Comparative Example 1 was obtained in the same manner as in Reference Example 1 except that a second pellicle film was formed using the same second dispersion liquid as in Example 1 instead of the first dispersion liquid.

Film Formability of Pellicle Film

To evaluate film formability of a pellicle film, besides the above-described circular pellicle film having a size with a diameter of 2 mm (2 mmΦ), a pellicle film having a size of 1 cm square (1 cm × 1 cm), i.e., having a larger area was formed. The film was formed by the same method as the method described above except that the size of the formed film was changed.
The evaluation results of film formability of the pellicle films are shown in Table 1. The evaluation criteria are as follows.

"A": The pellicle film having a size of 1 cm square could be formed.
"C": The pellicle film having a size of 1 cm square could not be formed.

In Examples 1 to 8, since the pellicle film having a size of 1 cm square could be formed, the evaluation was "A".
In Comparative Example 1, since the pellicle film having a size of 1 cm square could not be formed, the evaluation was "C". In the case where the amounts of carbon nanotubes in the pellicle films of Examples, Reference Example, and Comparative Example were equalized to 1.0 $\mu$g/cm$^2$ in view of the light transmittances of the films, the number of carbon nanotubes contained in the pellicle film of Comparative Example 1 was smaller than that of Example 1, etc. because only the second carbon nanotubes, which were longer than the first carbon nanotubes, were used. It is considered that, therefore, in the pellicle film of Comparative Example 1, the number of points at which carbon nanotubes were in contact with each other was smaller than that in Example 1, etc., resulting in a decrease in the strength of the film, and thus the pellicle film having a size of 1 cm square could not be formed. In Comparative Example 1, the pellicle film having a size (2 mm in diameter) applicable to SEM observation could be formed.

Void Analysis of Pellicle Film

Average Pore Diameter, Maximum Pore Diameter, and Aperture Ratio

A surface of the pellicle film obtained in each Example was observed with a SEM (product name: CrossBeam550, manufactured by Carl Zeiss) to acquire image data of six SEM images. Image-capturing conditions were an accelerating voltage of 1 kV and a magnification of 10,000 times. In the cases where the pellicle film was a multilayer film, the pellicle film was observed from the second pellicle film side in the SEM observation. SEM is an abbreviation of Scanning Electron Microscope.

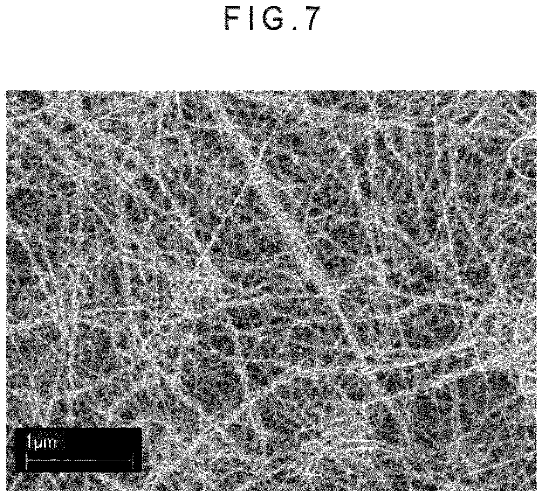

Fig. 7 shows a SEM image of the pellicle film according to Example 5. Fig. 7 is an SEM image of the pellicle film of Example 5 as observed from the second pellicle film side. As shown in Fig. 7, the second pellicle film containing the second carbon nanotubes having a long length was observed on the near side, and the formation of the first pellicle film containing the first carbon nanotubes having a short length on the far side was observed.

On the basis of the image data of the obtained SEM image, void diameters (pore sizes) were analyzed as equivalent circle diameters. First, for one field of view of the image data of the SEM image, seven initial binarization thresholds were set between a pixel value of 40 and a pixel value of 160 at equal intervals of 20 pixel values at 40, 60, 80, 100, 120, 140, and 160, and seven binarized image data were obtained on the basis of these binarization thresholds. This operation was performed on the image data of three or more fields of view. Next, for the obtained binarized image data, the initial distribution of void diameters based on the initial binarization thresholds was measured. Subsequently, fitting was performed using Bayesian optimization such that the actual value of the distribution of void diameters closely approximated (fitted) the log-normal distribution, thereby automatically searching binarization thresholds that minimized the difference between the actual value of the distribution of void diameters and the theoretical value of the distribution of void diameters. Subsequently, from the distribution of void diameters and the distribution of the aperture ratio measured on the basis of the binarization thresholds at which the difference between the actual value of the distribution of void diameters and the theoretical value of the distribution of void diameters was minimized, the average void diameter (the average pore diameter), the maximum void diameter (maximum pore diameter), and the aperture ratio were calculated.

Table 1 shows the evaluation results of the void characteristics of the pellicle films. The evaluation criteria are as follows.

Evaluation Criteria of Average Pore Diameter

"A": The average pore diameter was within a range between Reference Example 1 and Comparative Example 1.

Evaluation Criteria of Aperture Ratio

"A": The aperture ratio was within a range of $\pm$ 5% of the aperture ratio of Reference Example 1.

Evaluation Criteria of Maximum Pore Diameter

"A": The maximum pore diameter was 200 nm or less.
"B": The maximum pore diameter was smaller than the maximum pore diameter of Reference Example 1.

Regarding the notation of the film configuration in Table 1, "First/Second" indicates that a second pellicle film is previously formed, and a first pellicle film is subsequently formed, so that the first pellicle film is stacked on the second pellicle film. "Second/First" indicates that a first pellicle film is previously formed, and a second pellicle film is subsequently formed, so that the second pellicle film is stacked on the first pellicle film. "Third/First/Second" indicates that a second pellicle film is previously formed, a first pellicle film is subsequently formed, and a third pellicle film is subsequently formed, so that the second pellicle film, the first pellicle film, and the third pellicle film are stacked in this order.

In Table 1, carbon nanotubes are abbreviated as "CNTs".

[Table 1]

| | Film configuration | Mass ratio | | | Amount of CNTs | Average pore diameter | | Aperture ratio | | Maximum pore diameter | | Film formability (Size: 1 cm$^2$) | Overall evaluation |
|---|---|---|---|---|---|---|---|---|---|---|---|---|---|
| | | First CNTs | Second CNTs | Third CNTs | [$\mu$g/cm$^2$] | [nm] | Evaluation | [%] | Evaluation | [nm] | Evaluation | | |
| Example 1 | Single-layer film | 90 | 10 | - | 1.0 | 33.2 | A | 13.0 | A | 233.6 | B | A | B |
| Example 2 | Single-layer film | 50 | 50 | - | 1.0 | 34.3 | A | 12.9 | A | 231.0 | B | A | B |
| Example 3 | Single-layer film | 10 | 90 | - | 1.0 | 37.3 | A | 12.6 | A | 197.2 | A | A | A |
| Example 4 | Multilayer film Two layers: First/Second | 80 | 20 | - | 1.0 | 31.5 | A | 9.5 | A | 195.8 | A | A | A |
| Example 5 | Multilayer film Two layers: First/Second | 50 | 50 | - | 1.0 | 35.3 | A | 10.9 | A | 184.8 | A | A | A |
| Example 6 | Multilayer film Two layers: First/Second | 50 | 50 | - | 0.8 | 34.9 | A | 14.9 | A | 194.5 | A | A | A |
| Example 7 | Multilayer film Two layers: Second/First | 50 | 50 | - | 1.0 | 36.1 | A | 10.9 | A | 217.3 | B | A | B |
| Example 8 | Multilayer film Three layers: Third/First/Second | 33 | 33 | 33 | 1.0 | 35.0 | A | 10.7 | A | 221.0 | B | A | B |
| Reference Example 1 | Single-layer film | 100 | - | - | 1.0 | 31.0 | - | 13.1 | A | 309.5 | B | A | B |
| Comparative Example 1 | Single-layer film | - | 100 | - | 1.0 | 37.8 | - | 12.0 | A | 230.1 | B | C | C |

As shown in Table 1, when the mass ratio of carbon nanotubes contained in the film was changed in Examples 1 to 8, the average pore diameters of the pellicle films of Examples 1 to 8 showed values between the average pore diameter of the pellicle film of Reference Example 1 and the average pore diameter of the pellicle film of Comparative Example 1. That is, it was found that pellicle films having desired average pore diameters could be obtained by changing the mass ratio of the carbon nanotubes.

Furthermore, as shown in Table 1, when the mass ratio of carbon nanotubes contained in the film was changed in Examples 1 to 8, there was no significant difference in aperture ratio, which contributes to the light transmittance of the pellicle film, (the aperture ratios were at the same level) compared with Reference Example 1. Thus, even when the mass ratio of the carbon nanotubes was changed, a significant variation in the aperture ratio was inhibited, showing that the light transmittance was ensured.

The maximum pore diameter is an indicator that reflects the presence of a large pore (void) in the SEM image of the pellicle film. As shown in Table 1, the maximum pore diameter of the pellicle film of Reference Example 1 was large. In contrast, the maximum pore diameters of the pellicle films of Examples 1 to 8 were sufficiently smaller than that of Reference Example 1, showing that large pores were not suddenly formed in the pellicle films.

As described above, pellicle films having desired void characteristics were obtained by incorporating, in a single-layer film or a multilayer film, carbon nanotubes serving as a plurality of types of fibrous materials satisfying different length ranges as in the pellicle films of Examples 1 to 8. Thus, according to the pellicle film according to the invention, the void characteristics were found to be easily controlled. It should be noted that, even in a case where materials other than carbon nanotubes are used as the fibrous materials, a pellicle film having desired void characteristics is expected to be obtained as in the case of using carbon nanotubes.

EXPLANATION OF CODES

1 $\cdots$ first fibrous material, 2 $\cdots$ second fibrous material, 3 $\cdots$ third fibrous material, 10 $\cdots$ first pellicle film, 20 $\cdots$ second pellicle film, 20A $\cdots$ second pellicle film, 20B $\cdots$ third pellicle film, 30 $\cdots$ support, 31 $\cdots$ frame, 32 $\cdots$ opening, 34 $\cdots$ support surface, 100 $\cdots$ pellicle film, 101 $\cdots$ first pellicle film surface, 102 $\cdots$ second pellicle film surface, 103 $\cdots$ peripheral portion, 110 $\cdots$ pellicle film, 111 $\cdots$ first pellicle film surface, 112 $\cdots$ second pellicle film surface, 113 $\cdots$ peripheral portion, 120 $\cdots$ pellicle film, 121 $\cdots$ first pellicle film surface, 122 $\cdots$ second pellicle film surface, 123 $\cdots$ peripheral portion, 200 $\cdots$ pellicle, 210 $\cdots$ pellicle, 220 $\cdots$ pellicle

**Claims**

1. A pellicle film comprising a first fibrous material and a second fibrous material,

   wherein a length $L_{FB1}$ of the first fibrous material is 20 $\mu$m or less, and
   a length $L_{FB2}$ of the second fibrous material is 100 $\mu$m or more and less than 250 $\mu$m.

2. The pellicle film according to claim 1,

   wherein the pellicle film is a single-layer film, and
   the first fibrous material and the second fibrous material coexist in the single-layer film.

3. The pellicle film according to claim 2,
   wherein a mass ratio ($M_{FB1}:M_{FB2}$) of a mass $M_{FB1}$ of the first fibrous material to a mass $M_{FB2}$ of the second fibrous material in the single-layer film is 10:90 to 90:10.

4. The pellicle film according to claim 2 or 3,
   wherein a total of a mass percentage of the first fibrous material in the single-layer film and a mass percentage of the second fibrous material in the single-layer film is 90 mass% or more.

5. The pellicle film according to claim 1,

   wherein the pellicle film is a multilayer film including a first pellicle film and a second pellicle film,
   the first pellicle film and the second pellicle film are stacked,
   the first pellicle film contains the first fibrous material, and
   the second pellicle film contains the second fibrous material.

**6.** The pellicle film according to claim 5,
wherein a mass ratio ($M_{FB1}$:$M_{FB2}$) of a mass $M_{FB1}$ of the first fibrous material to a mass $M_{FB2}$ of the second fibrous material in the multilayer film is 50:50 to 80:20.

**7.** The pellicle film according to claim 5 or 6,
wherein a total of a mass percentage of the first fibrous material in the multilayer film and a mass percentage of the second fibrous material in the multilayer film is 90 mass% or more.

**8.** The pellicle film according to claim 5 or 6,

wherein the pellicle film further includes a third pellicle film,
the second pellicle film, the first pellicle film, and the third pellicle film are stacked in this order,
the third pellicle film contains a third fibrous material having a length of 100 $\mu$m or more and less than 250 $\mu$m, and
the second fibrous material and the third fibrous material are the same or different from each other.

**9.** The pellicle film according to claim 8,
wherein a mass ratio ($M_{FB1}$:($M_{FB2}$ + $M_{FB3}$)) of a mass $M_{FB1}$ of the first fibrous material to a total mass $M_{FB2}$ + $M_{FB3}$ of a mass $M_{FB2}$ of the second fibrous material and a mass $M_{FB3}$ of the third fibrous material in the multilayer film is 33:67 to 80:20.

**10.** The pellicle film according to claim 8,
wherein a total of a mass percentage of the first fibrous material, a mass percentage of the second fibrous material, and a mass percentage of the third fibrous material in the multilayer film is 80 mass% or more.

**11.** The pellicle film according to claim 1, 2, or 5,
wherein the length $L_{FB1}$ of the first fibrous material is in a range from 1 $\mu$m to 20 $\mu$m.

**12.** The pellicle film according to claim 1, 2, or 5,
wherein the length $L_{FB2}$ of the second fibrous material is in a range from 100 $\mu$m to 200 $\mu$m.

**13.** The pellicle film according to claim 1 or 2,
wherein the pellicle film has a self-standing property.

**14.** A pellicle comprising:

the pellicle film according to claim 1, 2, or 5; and
a support that has a frame and an opening surrounded by the frame and that supports the pellicle film.

FIG.1

# FIG.2

## F I G . 3

FIG.4

# FIG.5

# FIG.6

# FIG.7

1μm

## INTERNATIONAL SEARCH REPORT

| International application No. |
|---|
| **PCT/JP2024/011772** |

| A. | CLASSIFICATION OF SUBJECT MATTER |
|---|---|

*G03F 1/62*(2012.01)i
FI:   G03F1/62

According to International Patent Classification (IPC) or to both national classification and IPC

| B. | FIELDS SEARCHED |
|---|---|

Minimum documentation searched (classification system followed by classification symbols)

G03F1/62

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2022-534476 A (LINTEC OF AMERICA, INC.) 01 August 2022 (2022-08-01) claim 4 | 1-14 |
| A | JP 2023-24406 A (TAIWAN SEMICONDUCTOR MANUFACTUARING CO., LTD.) 16 February 2023 (2023-02-16) paragraph [0024] | 1-14 |
| A | JP 2020-160345 A (MITSUI CHEMICALS, INC.) 01 October 2020 (2020-10-01) paragraph [0038] | 1-14 |
| A | JP 2018-194838 A (IMEC VZW) 06 December 2018 (2018-12-06) paragraph [0067] | 1-14 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 April 2024** | **07 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
Information on patent family members

International application No.

**PCT/JP2024/011772**

| Patent document cited in search report | | | Publication date (day/month/year) | Patent family member(s) | | | Publication date (day/month/year) |
|---|---|---|---|---|---|---|---|
| JP | 2022-534476 | A | 01 August 2022 | US | 2022/0144641 | A1 | |
| | | | | claim 4 | | | |
| | | | | WO | 2020/243112 | A1 | |
| JP | 2023-24406 | A | 16 February 2023 | US | 2023/0037580 | A1 | |
| | | | | paragraph [0033] | | | |
| | | | | CN | 115437208 | A | |
| JP | 2020-160345 | A | 01 October 2020 | (Family: none) | | | |
| JP | 2018-194838 | A | 06 December 2018 | US | 2018/0329291 | A1 | |
| | | | | paragraph [0070] | | | |
| | | | | EP | 3404486 | A1 | |
| | | | | CN | 108878259 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018008594 A